# EUROPÄISCHE PATENTSCHRIFT

(11) **EP 0 391 464 B1**
(45) Veröffentlichungstag und Bekanntmachung des Hinweises auf die Patenterteilung: **22.06.1994**
(21) Anmeldenummer: 90200731.9
(22) Anmeldetag: 28.03.1990
(51) Int. Cl.: H03L 7/093

(54) **Hybrider Phasenregelkreis**
Hybrid phase locked loop
Boucle d'asservissement de phase hybride

(30) Priorität: 03.04.1989 DE 3910703
(43) Veröffentlichungstag der Anmeldung: 10.10.1990
(73) Patentinhaber: Philips Patentverwaltung GmbH, 22335 Hamburg (DE); Philips Electronics N.V., 5621 BA Eindhoven (NL)
(72) Erfinder: Schmidt, Konrad, Dipl.-Ing., D-8836 Ellingen (DE); Krämer, Ralf, Dipl.-Phys., D-8500 Nürnberg (DE)
(74) Vertreter: Peuckert, Hermann, Dipl.-Ing.

(56) Entgegenhaltungen:
- EP-A- 0 199 448
- DE-A- 3 126 116
- US-A- 4 550 292
- PATENT ABSTRACTS OF JAPAN vol. 012, no. 369 (E-665) 04 Oktober 1988, & JP-A-63 121316 (NEC CORP) 25 Mai 1988,

## Beschreibung

Die Erfindung betrifft einen Phasenregelkreis mit einem Phasenvergleicher, einem AD-Wandler, einem digitalen Schleifenfilter, einem DA-Wandler und einem spannungsgesteuerten Oszillator.

Ein derartiger Phasenregelkreis (PLL = phase locked loop) ist beispielsweise aus dem Artikel "On Optimum Digital Phase-Locked Loops" von S.C. Gupta in IEEE Trans. Commun. Tech., Vol. COM-16, Seiten 340 bis 344, April 1968 bekannt. Derartige Phasenregelkreise werden als hybride Phasenregelkreise bezeichnet, da sowohl analoge als auch digitale Komponenten verwendet werden. Solche Phasenregelkreise sind beispielsweise für die Taktrückgewinnung hochstabiler Takte digitaler Übertragungsnetze der Nachrichtentechnik geeignet. Der Phasenregelkreis besteht dabei im wesentlichen aus einem spannungsgesteuerten Oszillator (VCO = voltage controlled oscillator), einem Phasenvergleicher (PD = phase detector), einem Analog-Digital-Wandler, einem digital arbeitenden Schleifenfilter (LF = loop filter) sowie einem Digital-Analog-Wandler. Der Phasenvergleicher vergleicht die Phasenlage eines vom spannungsgesteuerten Oszillator erzeugten Signals mit der Phasenlage eines Eingangssignals und erzeugt eine Regelspannung, die den Oszillator so lange nachführt, bis die Phasendifferenz minimal ist bzw. einen vorgegebenen Sollwert erreicht.

Der Frequenz des Oszillators eines hybriden Phasenregelkreises kann nur in diskreten Schritten verstellt werden, deren Größe von der Auflösung des DA-Wandlers abhängt, d.h. von dem Digitalwert (bit) mit der geringsten Wertigkeit (LSB = least significant bit). Dies hat zur Folge, daß die Frequenz des Ausgangssignals des Phasenregelkreises immer um einen bestimmten Wert von der Frequenz des Eingangssignals des Phasenregelkreises abweicht. Ist der Phasenregelkreis eingeschwungen und weist die Eingangsfrequenz eine Instabilität auf, so wird der DA-Wandler um mindestens ein LSB geschaltet. Daraus entsteht ein Phasenjitter des Ausgangssignals, der zu Problemen führen kann. Sollen beispielsweise zwei gleichartige Systeme phasenstarr gekoppelt werden, so wird dies durch den Phasenjitter erschwert oder gar unmöglich. Ein weiteres Problem ergibt sich beim Ausfall der Eingangsfrequenz. Der Oszillator schwingt dann mit seiner momentanen Frequenz weiter, die je nach der Höhe der zuletzt aufgetretenen Frequenzabweichung mehr oder weniger von einer Referenzfrequenz abweicht.

Um den Phasenjitter am Ausgang des Oszillators auf ein Mindestmaß zu begrenzen, muß die Auflösung des AD-Wandlers so gewählt werden, daß das Produkt aus der Änderung von einem LSB am Ausgang des AD-Wandlers und dem Proportionalitätsfaktor des Schleifenfilters gerade eine Änderung von einem LSB des DA-Wandlers zur Folge hat. Daraus wird ersichtlich, daß der Phasenjitter eines so ausgelegten hybriden Phasenregelkreises nur noch weiter verringert werden kann, wenn die Auflösung sowohl des DA-Wandlers als auch die des AD-Wandlers erhöht wird. Dies bedeutet jedoch gleichzeitig zusätzlichen Aufwand und somit höhere Kosten.

Der Erfindung liegt die Aufgabe zugrunde, einen Phasenregelkreis der eingangs genannten Art anzugeben, mit dem der Phasenjitter reduziert werden kann, ohne die Anforderungen an die Auflösung des DA-Wandlers zu erhöhen.

Die Aufgabe wird bei einem Phasenregelkreis der eingangs genannten Art dadurch gelöst, daß dem mit einem ersten Takt getakteten digitalen Schleifenfilter ein Fraktionierer nachgeschaltet ist, der einen Haupt- und einen Restwert bildet, wobei dem mit einem zweiten Takt getakteten DA-Wandler die Summe aus dem Hauptwert und aus einem vom Restwert abgeleiteten Korrekturbit zugeführt wird.

Vorteilhafte Ausgestaltungsformen sind in den Unteransprüchen enthalten.

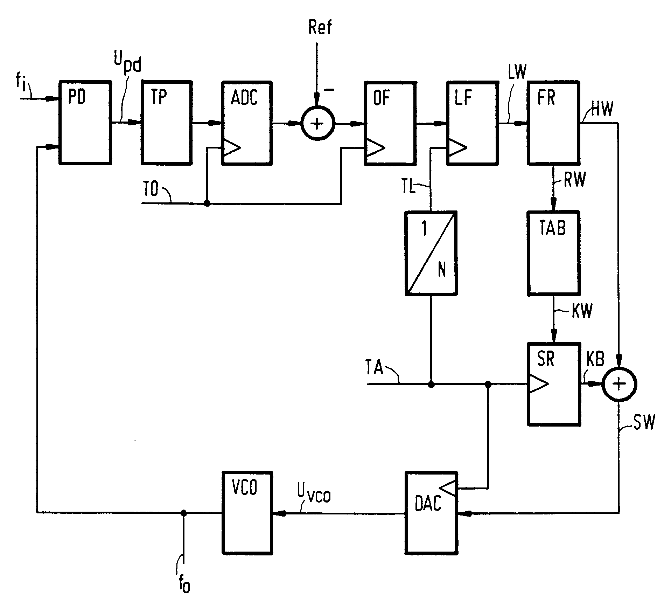

Im folgenden wird die Erfindung anhand eines in der Figur dargestellten Ausführungsbeispiels näher erläutert.

Die Figur zeigt einen hybriden Phasenregelkreis.

Der in der Figur dargestellte Phasenregelkreis weist einen Phasenvergleicher PD auf, dem ein externes Signal mit einer Normalfrequenz fᵢ und ein von einem spannungsgesteuerten Oszillator VCO erzeugtes Signal mit einer Frequenz fₒ zugeführt wird. Der Phasenvergleicher PD vergleicht die Phasenlage der Frequenzen fᵢ, fₒ und liefert eine von der Phasenverschiebung abhängige Spannung U_{pd}. Die Spannung U_{pd} wird über einen Tiefpaß TP, der störende Frequenzanteile ausfiltert, einem AD-Wandler ADC zugeführt. Nach dem Vergleich mit einem Referenzwert Ref ist im Phasenregelkreis ein Oversample-Filter OF zwischengeschaltet, das eine erhöhte Auflösung bewirkt. Dabei arbeiten der AD-Wandler ADC und das Oversample-Filter OF mit einem gemeinsamen dritten Takt TO. Die Ausgangswerte des Oversample-Filters OF werden einem digitalen Schleifenfilter LF zugeführt, das in Software (d.h. mittels eines geeignet programmierten digitalen Signal-Prozessors) realisiert ist und mit einem ersten Takt TL arbeitet. Die errechneten Schleifenfilterausgangswerte LW werden in einem sogenannten Fraktionierer FR in einen Hauptwert HW mit der Bitbreite des DA-Wandlers und einen Restwert RW aufgespalten. Der Restwert RW wird als Adresse einem Tabellenlesespeicher TAB zugeführt und selektiert daraus einen entsprechenden Korrekturwert KW. Die einzelnen Bits des Korrekturwertes KW werden parallel mit dem ersten Takt TL in das Schieberegister SR geladen. Ein Korrekturbit KB des Korrekturwertes KW wird als LSB mit einem zweiten Takt TA aus dem Schieberegister ausgelesen und anschließend mit dem Hauptwert HW zu einem Summenwert SW aufsummiert. Der Summenwert SW wird anschließend dem DA-Wandler DAC zugeführt. Ein Analogsignal U_{vco} am Ausgang des DA-Wandlers DAC wird auf den Eingang des spannungsgesteuerten Oszillators VCO geschaltet, der daraus das Signal mit der Frequenz fₒ erzeugt.

Bei dem in der Figur gezeigten hybriden Phasenregelkreis wird vorausgesetzt, daß sowohl der AD-Wandler ADC als auch der DA-Wandler DAC eine Genauigkeit von mindestens einem halben LSB aufweisen ("no missing code"). Die Wortlänge des Hauptwertes HW entspricht der Bitbreite des DA-Wandlers DAC, während der Korrekturwert KW eine Länge N aufweist, die dem Verhältnis des zweiten Taktes TA des DA-Wandlers und des ersten Taktes TL des Schleifenfilters LF entspricht.

Bei den Signalen am Eingang des Phasenvergleichers PD handelt es sich bei dem in der Figur dargestellten Ausführungsbeispiel um Rechtecksignale. Durch die Tiefpaßfilterung TP der Spannung U_{pd} am Ausgang des Phasenvergleichers PD wird ein Gleichspannungsmittelwert erzeugt, der von einem AD-Wandler ADC zu einem Digitalwert weiterverarbeitet wird. Beim Ausführungsbeispiel kommt ein 12 Bit AD-Wandler zum Einsatz, der mit 16 Hz getaktet wird. Durch Subtraktion des einem Phasensollwert entspechenden digitalen Referenzwertes Ref von dem Digitalwert am Ausgang des AD-Wandlers ADC wird ein Wert gebildet, dessen Auflösung durch Zwischenschaltung des Oversample-Filters OF auf 16 Bit erhöht wird. Das digital arbeitende Schleifenfilter LF vollzieht das Verhalten eines analogen Schleifenfilters nach und wird beim Ausführungsbeispiel mit 1/16 des zweiten Taktes TA, d.h. mit 1 Hz, getaktet. Beim Ausführungsbeispiel entspicht der dritte Takt TO dem zweiten Takt TA. Bei einem weiteren Ausführungsbeispiel ist der zweite Takt TA des DA-Wandlers DAC und des Schieberegisters SR größer als der dritte Takt TO des AD-Wandlers bzw. des Oversample-Filters OF. Der Fraktionierer FR, der ebenfalls in Software realisiert ist, bildet beim Ausführungsbeispiel aus dem Schleifenfilter-Ausgangswert LW mit einer Wortlänge von beispielsweise 24 Bit den Hauptwert HW mit einer Wortlänge von 12 Bit und den Restwert RW mit einer Wortlänge von 4 Bit. Die verbleibenden 8 Bit werden beim Ausführungsbeispiel nicht weiter berücksichtigt. Die Information des Restwertes RW wird beispielsweise durch ein Rechenverfahren weiterverarbeitet oder es wird entsprechend dem Ausführungsbeispiel durch Zuführung des Restwertes RW als Adresse zu dem Tabellenlesespeicher TAB der Korrekturwert KW erhalten, der eine Wortlänge von 16 Bit aufweist. Dabei entspricht das Verhältnis der binären Eins- und Nullwerte zueinander der Wertigkeit des Restwertes RW, wobei vorteilhafterweise die binären Eins- und Nullwerte möglichst gleich verteilt sind. Die 16 Bit des mit dem Takt TL gebildeten Korrekturwertes KW werden nun ebenfalls mit dem Takt TL parallel in das Schieberegister SR geladen. Das Auslesen der einzelnen Korrekturbits KB des Korrekturwertes KW aus dem Schieberegister SR erfolgt dagegen mit dem Takt TA (16 Hz), der beim Ausführungsbeispiel dem 16-fachen des Taktes TL des Schleifenfilters LF entspricht. Das Korrekturbit KB und der Hauptwert HW werden zum Summenwert SW summiert. Bis hierher, d.h. vom Oversample-Filter OF bis zur Bildung des Summenwertes SW, kann der Phasenregelkreis in Software realisiert werden. Die damit verbundene Einsparung entsprechender Hardwarelösungen führt zu einer kostengünstigen Realisierung des Phasenregelkreises. Der Summenwert SW wird durch den ebenfalls mit dem Takt TA arbeitenden DA-Wandler DAC in eine analoge Spannung U_{vco} umgewandelt, die den Oszillator VCO öfter, d.h. beim Ausführungsbeispiel 16 mal so oft, verstellt, als dies ohne Bildung des Korrekturwertes KW der Fall wäre. Dadurch wird die mittlere Frequenz fₒ am Ausgang des im Ausführungsbeispiel temperaturgeregelten Oszillators VCO näher an die Frequenz fᵢ am Eingang des Phasenregelkreises angepaßt und somit der resultierende Phasenjitter deutlich reduziert.

Bei einer weiteren Steigerung des Taktes TA des DA-Wandlers DAC und des Schieberegisters SR sowie einer Erhöhung des Taktes TO des Oversample-Filters OF bzw. einer Erhöhung der Rechengenauigkeit des Schleifenfilters LF verhält sich der hybride Phasenregelkreis immer mehr wie ein analoger Phasenregelkreis. Darüber hinaus wird im Freilauffall, d.h. beim Ausfall des Referenzwertes Ref, die mittlere Frequenzabweichung des Oszillators VCO wesentlich vermindert, da der Schleifenfilterausgangswert LW in diesem Fall festgehalten und wie oben beschrieben zum Summenwert SW weiterverarbeitet wird.

## Patentansprüche

1. Phasenregelkreis mit einem Phasenvergleicher, einem AD-Wandler, einem digitalen Schleifenfilter, einem DA-Wandler und einem spannungsgesteuerten Oszillator,
dadurch gekennzeichnet,
daß dem mit einem ersten Takt (TL) getakteten digitalen Schleifenfilter (LF) ein Fraktionierer (FR) nachgeschaltet ist, der einen Hauptwert (HW) und einen Restwert (RW) bildet, wobei dem mit einem zweiten, höheren Takt (TA) getakteten DA-Wandler (DAC) die Summe aus dem Hauptwert (HW) und aus einem vom Restwert (RW) abgeleiteten Korrekturbit (KB) zugeführt wird.

2. Phasenregelkreis nach Anspruch 1,
dadurch gekennzeichnet,
daß das Korrekturbit (KB) einem Bit eines Korrekturwertes (KW) entspricht, daß einem Schieberegister (SR) zugeführt wird, wobei das Korrekturbit (KB) mit dem zweiten Takt (TA) aus dem Schieberegister (SR) ausgelesen wird.

3. Phasenregelkreis nach einem der Ansprüche 1 oder 2,
dadurch gekennzeichnet,
daß der Korrekturwert (KW) eine Länge (N) aufweist, die dem Verhältnis des zweiten Taktes (TA) des DA-Wandlers (DAC) und des ersten Taktes (TL) des digitalen Schleifenfilters (LF) entspricht und daß die Wortlänge des Hauptwertes (HW) der Bitbreite des DA-Wandlers (DAC) entspricht.

4. Phasenregelkreis nach einem der Ansprüche 1 bis 3,
dadurch gekennzeichnet,
daß dem digitalen Schleifenfilter (LF) ein Oversample-Filter (OF) vorgeschaltet ist, wobei der AD-Wandler (ADC) und das Oversample Filter (OF) einen gemeinsamen dritten Takt (TO) aufweisen.

5. Phasenregelkreis nach einem der Ansprüche 1 bis 4,
dadurch gekennzeichnet,
daß der Korrekturwert (KW) durch Zuführung des Restwertes (RW) als Adresse zu einem Tabellenlesespeicher (TAB) erhalten wird.

6. Phasenregelkreis nach einem der Ansprüche 1 bis 5,
dadurch gekennzeichnet,
daß das Korrekturbit (KB) durch ein Rechenverfahren gebildet wird.

7. Phasenregelkreis nach einem der Ansprüche 1 bis 6,
dadurch gekennzeichnet,
daß dem Phasenvergleicher (PD) ein Tiefpaßfilter (TP) nachgeschaltet ist.

8. Phasenregelkreis nach einem der Ansprüche 1 bis 7,
dadurch gekennzeichnet,
daß der zweite Takt (TA) dem dritten Takt (TO) entspricht.

## Claims

1. Phase-locked loop comprising a phase detector, an analog-to-digital converter, a digital loop filter, a digital-to-analog converter and a voltage-controlled oscillator, characterized in that a fractionizer (FR) is inserted after the digital loop filter (LF) that is operating at a first clock (TL), which fractionizer produces a main value (HW) and a residual value (RW), and the sum of the main value (HW) and a correction bit (KB) derived from the residual value (RW) is applied to the digital-to-analog converter (DAC) that is operating at a second, higher clock (TA).

2. Phase-locked loop as claimed in Claim 1, characterized in that the correction bit (KB) is equal to one bit of the correction value (KW) that is applied to a shift register (SR), and the correction bit (KB) is read out from the shift register (SR) at the second clock (TA).

3. Phase-locked loop as claimed in one of the Claims 1 or 2, characterized in that the correction value (KW) has a word length (N) corresponding with the ratio of the second clock (TA) of the digital-to-analog converter (DAC) to the first clock (TL) of the digital loop filter (LF), and in that the word length of the main value (HW) corresponds with the number of bits that can be transmitted by the digital-to-analog converter (DAC).

4. Phase-locked loop as claimed in one of the Claims 1 to 3, characterized in that an oversample filter (OF) is inserted after the loop filter (LF), whereas the analog-to-digital (ADC) converter and the oversample filter (OF) operate at a common third clock (TO).

5. Phase-locked loop as claimed in one of the Claims 1 to 4, characterized in that the correction value (KW) is obtained by applying the residual value (RW) as an address to a table look-up memory (TAB).

6. Phase-locked loop as claimed in one of the Claims 1 to 5, characterized in that the correction bit (KB) is formed by means of a calculation method.

7. Phase-locked loop as claimed in one of the Claims 1 to 6, characterized in that a low-pass filter (TP) is inserted after the phase detector (PD).

8. Phase-locked loop as claimed in one of the Claims 1 to 7, characterized in that the second clock (TA) is equal to the third clock (TO).

## Revendications

1. Boucle d'asservissement de phase comportant un comparateur de phase, un convertisseur AN, un filtre de boucle numérique, un convertisseur NA et un oscillateur commandé en tension, caractérisée en ce que l'on installe en aval du filtre de boucle (LF) numérique cadencé à un premier rythme (TL), un fractionneur (FR), qui forme une valeur principale (HW) et une valeur résiduelle (RW), la somme de la valeur principale (HW) et d'un bit de correction (KB) tiré de la valeur résiduelle (RW) étant acheminée au convertisseur NA (DAC) cadencé à un deuxième rythme plus élevé (TA).

2. Boucle d'asservissement de phase selon la revendication 1, caractérisée en ce que le bit de correction (KB) correspond à un bit d'une valeur de correction (KW), qui est acheminé à un registre à décalage (SR), le bit de correction (KB) étant extrait au deuxième rythme (TA) du registre à décalage (SR).

3. Boucle d'asservissement de phase selon l'une ou l'autre des revendications 1 et 2, caractérisée en ce que la valeur de correction (KW) présente une longueur (N), qui correspond au rapport du deuxième rythme (TA) du convertisseur NA (DAC) et du premier rythme (TL) du filtre de boucle numérique (LF) et la longueur de mot de la valeur principale (HW) correspond à la largeur de bit du convertisseur NA (DAC).

4. Boucle d'asservissement de phase selon l'une quelconque des revendications 1 à 3, caractérisée en ce que l'on monte en aval du filtre de boucle numérique (LF) un filtre oversample (OF), le convertisseur AN (ADC) et le filtre oversample (OF) présentant un troisième rythme commun (TO).

5. Boucle d'asservissement de phase selon l'une quelconque des revendications 1 à 4, caractérisée en ce que la valeur de correction (KW) est obtenue par acheminement de la valeur résiduelle (RW) en tant qu'adresse à une mémoire de lecture de tableaux (TAB).

6. Boucle d'asservissement de phase selon l'une quelconque des revendications 1 à 5, caractérisée en ce que le bit de correction (KB) est formé par une procédure de calcul.

7. Boucle d'asservissement de phase selon l'une quelconque des revendications 1 à 6, caractérisée en ce qu'un filtre passe-bas (TP) est monté en aval du comparateur de phase (PD).

8. Boucle d'asservissement de phase selon l'une quelconque des revendications 1 à 7, caractérisée en ce que le deuxième rythme (TA) correspond au troisième rythme (TO).
